# EUROPEAN PATENT SPECIFICATION

(11) **EP 4 573 859 B1**
(45) Date of publication and mention of the grant of the patent: **17.06.2026**
(21) Application number: 22764430.9
(22) Date of filing: 16.08.2022
(51) Int. Cl.: H10N 60/01, H10N 60/10, G06N 10/40, G03F 7/075

(54) **METHOD OF FABRICATING A SEMICONDUCTOR DEVICE**
VERFAHREN ZUR HERSTELLUNG EINER HALBLEITERANORDNUNG
PROCÉDÉ DE FABRICATION D'UN DISPOSITIF SEMI-CONDUCTEUR

(43) Date of publication of application: 25.06.2025
(73) Proprietor: Microsoft Technology Licensing LLC, Redmond, WA 98052-6399 (US)
(72) Inventor: SINGH, Amrita, Redmond, Washington 98052-6399 (US); CAROFF-GAONAC'H, Philippe, Redmond, Washington 98052-6399 (US); BOEKHOUT, Frederik, Redmond, Washington 98052-6399 (US); THOLAPI, Gowri Santhosh Nag Rajkiran, Redmond, Washington 98052-6399 (US); MEMISEVIC, Elvedin, Redmond,, Washington 98052-6399 (US)
(74) Representative: Page White Farrer
(86) International application number: PCT/EP2022/072871
(87) International publication number: WO 2024/037710

(56) References cited:
- WO-A1-2022/012749
- SU-A1- 763 841
- US-A1- 2022 052 056
- OL'SHVANGER B A ET AL: "FEASIBILITY OF USING A-ARSENIC IN VACUUM X-RAY LITHOGRAPHY", SOVIET PHYSICS TECHNICAL PHYSICS, AMERICAN INSTITUTE OF PHYSICS, NEW YORK, NY, US, vol. 34, no. 6, 1 June 1989 (1989-06-01), pages 685 - 686, XP000100160, ISSN: 0038-5662
- EUNSOON OH ET AL: "Optical characterizations of GaAs-based spin light emitting diodes using FeOspininjectors", CURRENT APPLIED PHYSICS, ELSEVIER, AMSTERDAM, NL, vol. 12, no. 5, 16 February 2012 (2012-02-16), pages 1244 - 1247, XP028507973, ISSN: 1567-1739, [retrieved on 20120308], DOI: 10.1016/J.CAP.2012.02.041
- PATEL SAHIL J ET AL: "Surface reconstructions and transport of epitaxial PtLuSb (001) thin films grown by MBE", JOURNAL OF CRYSTAL GROWTH, ELSEVIER, AMSTERDAM, NL, vol. 436, 12 December 2015 (2015-12-12), pages 145 - 149, XP029386499, ISSN: 0022-0248, DOI: 10.1016/J.JCRYSGRO.2015.12.003

## Description

### Background

Topological quantum computing is based on the phenomenon whereby non-abelian anyons, in the form of "Majorana zero modes" (MZMs), can be formed in regions where a semiconductor is coupled to a superconductor. A non-abelian anyon is a type of quasiparticle, meaning not a particle *per se,* but an excitation in an electron liquid that behaves at least partially like a particle. MZMs are a particular bound state of such quasiparticles.

Under certain conditions, MZMs can be formed close to an interface between a semiconductor and superconductor. For example, MZMs may be formed in a device comprising a semiconductor nanowire coated with a superconductor. A nanowire has a length which is many times greater than its diameter and can be considered as a 1-dimensional system. MZMs can also be formed in two-dimensional systems, comprising a superconductor coupled to a quantum well hosting a 2-dimensional electron gas, such as described by Suominen et al, Phys. Rev. Lett. 119, 176805 (2017) and Nichele et al, Phys. Rev. Lett. 119, 136803 (2017).

When MZMs are induced in a structure, the structure is said to be in the "topological regime". To induce this requires a magnetic field, conventionally applied externally, and also cooling of the structure to a temperature that induces superconducting behaviour in the superconductor material.

Topological devices are useful for creating a quantum bit which can be manipulated for the purpose of quantum computing. A quantum bit, also referred to as a qubit, is an element upon which a measurement with two possible outcomes can be performed, but which at any given time (when not being measured) can in fact be in a quantum superposition of the two states corresponding to the different outcomes.

To induce MZMs, the device is cooled to a temperature where the superconductor (e.g. aluminium) exhibits superconducting behaviour. The superconductor causes a proximity effect in the adjacent semiconductor, whereby a region of the semiconductor near the interface with the superconductor also exhibits superconducting properties. I.e. a topological phase behaviour is induced in the adjacent semiconductor as well as the superconductor. It is in this region of the semiconductor where the MZMs are formed.

Another condition for inducing the topological phase where MZMs can form is the application of a magnetic field in order to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. Typically, the magnetic field is applied by an external electromagnet.

The behaviour of semiconductor-superconductor hybrid devices is dependent upon the quality of the materials used, and the quality of the interfaces between those materials. There is a need for fabrication processes which can allow these requirements to be met.

One approach to fabrication is so-called *in situ* fabrication. In an *in situ* process, the semiconductor and superconductor components are all fabricated in the same apparatus while maintaining a very high vacuum. The device is not removed from the apparatus, nor is it exposed to the atmosphere.

Although *in situ* fabrication may allow high-quality devices to be obtained, the requirement to maintain a very high vacuum throughout the process is a significant constraint. Existing processes have limitations on scalability, yield, throughput, and reproducibility.

WO 2022/012749 A1 discloses a method of fabricating a semiconductor device on a substrate. The method comprises: forming a shadow wall on the substrate; subsequently growing a nanowire of semiconductor material on the substrate; and directionally depositing a layer of a further material on the nanowire from a direction selected such that the shadow wall casts a shadow on the nanowire, the shadow being a region in which the further material is not deposited. The nanowire is vertically orientated with respect to the substrate. The shadow wall comprises a base portion and a bridge portion. The bridge portion overhangs the substrate and the base portion supports the bridge portion. Patterning of the further material may be achieved without the use of etching, thereby avoiding damage to the semiconductor.

Ol'shvanger et al (Soviet Physics: Technical Physics, 34, no. 6, pp. 685-686) discloses x-ray lithography of As₂ layers using soft x-rays.

SU 763 841 A1 discloses methods for obtaining silver-free images on layers of elemental arsenic.

Oh et al (Current Applied Physics, 12, pp. 1244-1247) discloses fabrication of GaAs-based spin-LED structures. The spin-LED structures were grown on (001) p-GaAs substrates using molecular beam epitaxy.

Patel et al (Journal of Crystal Growth, 436, pp. 145-149) discloses a thin film of topological insulator PtLuSb grown on Al_{0.1}In_{0.9}Sb/GaAs by molecular beam epitaxy.

US 2022/052056 A1 discloses a semiconductor manufacturing method. The method includes: providing a semiconductor substrate, in which the semiconductor substrate includes an array region and a peripheral circuit region, in the array region, multiple capacitor contact holes are on the semiconductor substrate, and a first conductive layer is deposited on a bottom of each of the capacitor contact hole, and in the peripheral circuit region, a device layer is on the semiconductor substrate; treating the first conductive layer to increase its roughness; forming wire contact holes exposing the semiconductor substrate in the peripheral circuit region; forming a transition layer that at least covers a surface of the first conductive layer and a surface of the semiconductor substrate exposed by the wire contact holes; and forming a second conductive layer that covers the transition layer, and fills the capacitor contact holes and the wire contact holes.

### Summary

In one aspect there is provided a method of fabricating a semiconductor device, according to claim 1. The method includes providing a workpiece comprising a semiconductor structure, the semiconductor structure comprising a substrate and a semiconductor component arranged on a surface of the substrate; a capping layer over the semiconductor structure; and a shadow wall comprising a leg and a body connected to the leg. The capping layer is a layer of arsenic or antimony. The leg of the shadow wall extends from the semiconductor structure through an aperture in the capping layer. The body of the shadow wall is on the capping layer and over the semiconductor structure. The method further comprises removing the capping layer; and, after removing the capping layer, depositing a further material onto a first region of the semiconductor structure. The shadow wall prevents deposition of the further material onto a second region of the semiconductor structure.

The capping layer protects the surface of the semiconductor component, and can be removed without degrading the quality of the surface of the semiconductor component. This allows the further material to be deposited in an environment which is different from that in which the semiconductor structure is fabricated, while allowing a pristine interface between the semiconductor component and the further material to be obtained.

Another aspect provides a workpiece according to claim 13. The workpiece is useful in the method. The workpiece comprises a semiconductor structure, the semiconductor structure comprising a substrate and a semiconductor component arranged on a surface of the substrate; a capping layer over the semiconductor structure; and a shadow wall comprising a leg and a body connected to the leg. The capping layer is a layer of arsenic or antimony. The leg of the shadow wall extends from the semiconductor structure through an aperture in the capping layer. The body of the shadow wall is on the capping layer and over the semiconductor structure.

### Brief Description of the Drawings

To assist understanding of embodiments of the present disclosure and to show how such embodiments may be put into effect, reference is made, by way of example only, to the accompanying drawings in which:
Fig. 1 is a flow diagram outlining an example method of fabricating a semiconductor device;
Figs. 2A to 2E are schematic cross-sections of workpieces obtained at various stages of the method of Fig. 1;
Fig. 3 is a schematic perspective view of an example shadow wall;
Fig. 4 is a schematic plan view of an example shadow wall;
Fig. 5 is an annotated scanning electron microscopy image of a first example workpiece; and
Fig. 6 is a scanning electron microscopy image of a second example workpiece.

### Detailed Description

Directional terms such as "top", "bottom", "left", "right", "above", "below", "horizontal" and "vertical" are used herein for convenience of description, and refer to the orientation shown in the drawings. For the avoidance of any doubt, this terminology is not intended to limit the orientation of the device in an external frame of reference.

A first component which is "on" a second component is in direct contact with the second component. A first component which is "over" a second component may be directly on the second component, or spaced from the second component by one or more other components.

A "workpiece" is an intermediate product obtained during fabrication of a semiconductor device.

A high vacuum is an environment having a gas pressure of less than or equal to 100 mPa. An ultra-high vacuum is an environment having a gas pressure of less than or equal to 100 nPa.

As used herein, the term "superconductor" refers to a material which is capable of superconductivity when cooled to a temperature below a critical temperature, T_{c}, of the material.

The surface of a semiconductor may be described as pristine when it is in an "as-grown" state, substantially free of native oxides and other contaminants. When a metal is grown on a pristine surface of a semiconductor, the interface between the metal and the semiconductor may be described as pristine.

Described herein are methods of fabricating semiconductor devices, such as semiconductor-superconductor hybrid devices, using a combination of a removable capping layer and shadowing structures.

The methods provided herein may allow the surface of the semiconductor to be kept pristine. This may allow a high-quality semiconductor-superconductor interface to be obtained. The performance of a topological qubit based on a semiconductor-superconductor hybrid structure is highly dependent upon the quality of the interface.

In the methods, a semiconductor structure is prepared by growing a semiconductor component on a substrate. The growth typically takes place before any shadowing structures are formed on the substrate. The presence of shadowing structures during growth of a semiconductor component is not desirable. Shadowing structures hinder the diffusion of adatoms over the surface of the substrate. This makes it more difficult to obtain a flat, uniform film of semiconductor. The presence of shadowing structures during growth of the semiconductor may therefore reduce the quality and/or homogeneity of the semiconductor. Semiconductor materials which are grown at low temperature and/or from precursors with low diffusion coefficients are affected particularly badly by the present of shadow walls.

Shadowing structures may also impose other constraints on semiconductor growth, such as a limitation on the maximum thickness of the semiconductor component.

After preparing the semiconductor structure, the semiconductor structure is then capped with a layer of arsenic or antimony. Such capping layers may be applied to most surfaces. The capping layer allow the structure to be transferred between tools that do not share the same vacuum environment. This may allow the best available tools and materials to be used without the limitations associated with established *in situ* approaches: providing certain combinations of tools under the same vacuum environment may not always be possible.

Shadowing structures are then formed by a lithographic process. Lithographic processes may allow very high resolution, scalability, throughput, reproducibility and alignment, as well as high level of flexibility.

After forming the shadowing structures, the semiconductor structure may be loaded into a high-vacuum chamber. The capping layer may then be removed in a high vacuum environment.

Next, the shadowing structures are used to create desired patterns of a further material on the pristine surface of the semiconductor structure. A flow of material is directed toward the semiconductor structure. The shadowing structures block the flow, thereby defining shadowed regions which do not receive the material. Material is deposited in a controlled manner onto regions which are not shadowed.

The use of shadowing structures allows the further material to be patterned without the needed for destructive processes such as etching which could impact the performance of the device.

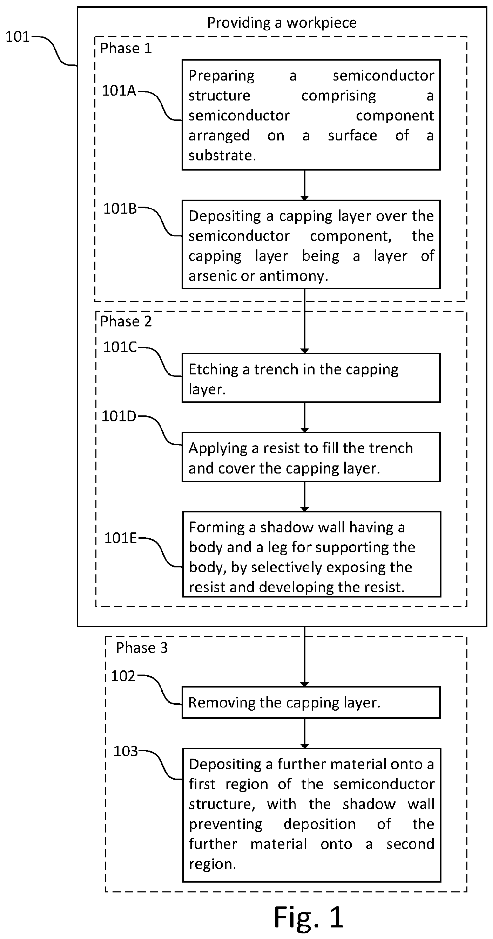

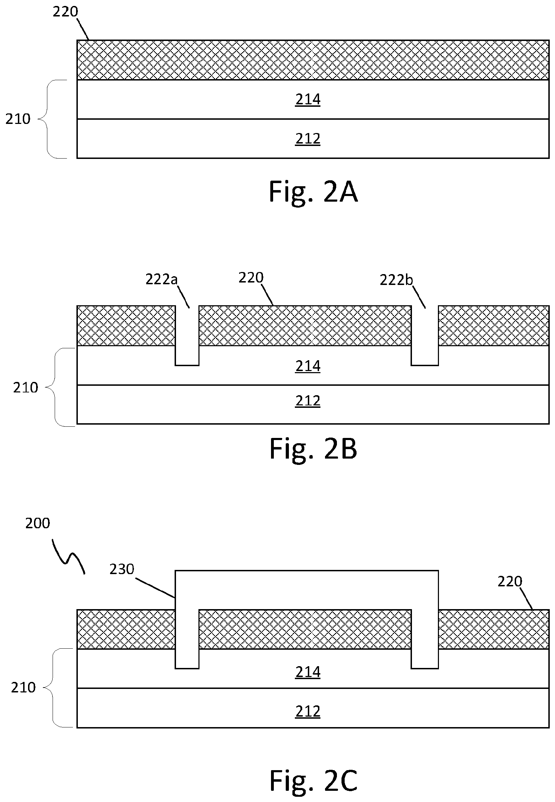

An example method of fabricating a semiconductor device will now be explained with reference to Figs. 1 and 2A to 2E. Fig. 1 is a flow diagram outlining the method, and Figs. 2A to 2E illustrate workpieces obtained at various stages of the method.

At block 101, a workpiece is provided. An example workpiece 200 is illustrated in Fig. 2C. The workpiece includes a semiconductor structure 210, comprising a substrate 212 and a semiconductor component 214 arranged on the substrate 212. A capping layer 220 covers the surface of the semiconductor structure 210. The capping layer is a layer of arsenic or antimony. The workpiece further includes a shadow wall 230. The shadow wall of this example has two legs, which extend from respective trenches in the semiconductor structure 210 and through respective apertures in the capping layer. The shadow wall 230 further includes a body extending between the legs. The body is spaced from the semiconductor structure 210 by the capping layer 220.

The substrate 212 provides a base on which the semiconductor component may be grown. The nature of the substrate is not particularly limited, and may be selected as appropriate depending upon the nature of the semiconductor component to be formed. The substrate 212 typically comprises a wafer, i.e. a piece of single crystalline material. The substrate 212 may comprise a III-V semiconductor material, such as indium phosphide, indium antimonide, indium arsenide, or gallium arsenide. Other wafer materials, such as silicon, may be used.

The semiconductor component 214 may comprise a semiconductor heterostructure, for example a semiconductor heterostructure for hosting a two-dimensional electron gas or a two-dimensional hole gas.

An example semiconductor heterostructure comprises a lower barrier arranged epitaxially on the substrate; a quantum well arranged epitaxially on the lower barrier; and an upper barrier layer arranged epitaxially on the quantum well. The quantum well comprises a material which is different from the material(s) of the lower barrier and upper barrier. The materials of the lower barrier layer and the upper barrier layer may each be independently selected.

The quantum well may comprise a layer of semiconductor material which has a relatively small band gap compared to the materials of the upper and lower barriers. Illustrative materials useful for forming quantum wells are described in, for example, Odoh and Njapba, "A Review of Semiconductor Quantum Well Devices", Advances in Physics Theories and Applications, vol. 46, 2015, pp. 26-32; and S. Kasap, P. Capper (Eds.), "Springer Handbook of Electronic and Photonic Materials", DOI 10.1007/978-3-319-48933-9_40.

The quantum well is typically a few atomic layers thick. For example, the quantum well may have a thickness in the range 2 to 7 nm. The configuration of the upper and lower barriers is not particularly limited provided that a 2-dimensional electron gas ("2DEG") or a 2-dimensional hole gas ("2DHG") can be formed in the quantum well layer. The lower barrier may comprise one or more layers of one or more different materials. The upper barrier may comprise one or more layers of one or more different materials. Constructing a barrier from a plurality of layers may provide defect filtering, i.e. may reduce the effects of dislocations in the crystalline structure of the materials used.

The semiconductor component may be fabricated by selective area growth. In such implementations, a dielectric mask used in the selective area growth may remain in the semiconductor structure.

The semiconductor material(s) used to form the semiconductor component are not particularly limited. The semiconductor component may for example comprise one or more III-V semiconductors, in particular a compound or allow comprising at least one group III element selected from indium, aluminium and gallium; and at least one group V element selected from arsenic, phosphorous, and antimony.

The III-V semiconductor material may include at least one of arsenic and antimony. In such implementations, fabrication of the semiconductor component and formation of the capping layer may both make use of the same source of arsenic or antimony.

The III-V semiconductor material may, for example, be a material of Formula 1:

InAsₓSb₁₋ₓ (Formula 1)

where x is in the range 0 to 1. In other words, the semiconductor component may comprise indium antimonide (x=0), indium arsenide (x=1), or a ternary mixture comprising 50 % indium on a molar basis and variable proportions of arsenic and antimony (0 <x <1).

Another class of materials useful as the semiconductor component are II-VI semiconductor materials. Examples of II-VI semiconductor materials include cadmium telluride, mercury telluride, lead telluride and tin telluride.

A capping layer 220 covers the semiconductor structure 210. The capping layer is a barrier which protects the semiconductor component 214 from its external environment. For example, if workpiece 200 is exposed to the atmosphere, capping layer 220 may protect the semiconductor component 214 from oxidation.

The capping layer 220 is a layer of arsenic or antimony. The capping layer may be an amorphous layer of arsenic or antimony.

The capping layer 220 will be removed at a later stage of the process, to allow deposition of a further material onto the semiconductor structure. Arsenic and antimony sublime when heated to a moderate temperature (e.g, a temperature of less than or equal to about 350 °C) in a high vacuum. It has been found that arsenic and antimony capping layers are effective for protecting pristine semiconductor surfaces, and are removable without degrading the surface of the semiconductor.

Arsenic has a lower sublimation temperature than antimony. Some semiconductor materials are temperature-sensitive, and minimising heating may be desirable in some implementations.

A shadow wall 230, also referred to as a shadowing structure, is partially embedded in the capping layer 220. The example shadow wall 230 has legs which extend through the capping layer 220 into trenches in the semiconductor structure. The shadow wall further has a body extending between the legs. The body rests on top of the capping layer 220. When the capping layer 220 is removed, the body overhangs the semiconductor structure with the legs providing mechanical support for the body.

The shadow wall 230 will be used later, after removal of the capping layer 220, to control deposition of a material onto the semiconductor structure 210. In use, the shadow wall 230 acts as a mask or stencil: the shadow wall 230 shields a region of the semiconductor structure 210 by blocking a flow of the material such that material is not deposited in the shielded region. The shielded region may be referred to as a shadow region.

The use of shadow walls may allow for non-destructive patterning of materials. In other words, materials may be deposited in a controlled manner without the need to remove excess material by chemical or physical methods. Removal of excess material, for example by etching, can damage the semiconductor structure.

Blocks 101A to 101E of Fig. 1 illustrate an example method for preparing workpiece 200.

Preparing the workpiece proceeds in two phases. In a first phase comprising blocks 101A and 101B, a workpiece comprising a semiconductor structure and a capping layer as illustrated in Fig. 2A is prepared. Subsequently, in a second phase comprising blocks 101C to 101E, a shadow wall is formed yielding a workpiece 200 as illustrated in Fig. 2C.

At block 101A of the first phase of the method, a semiconductor structure 210 comprising a semiconductor component 214 arranged on a surface of a substrate 212 is prepared.

The semiconductor component 214 is typically grown epitaxially on the surface of the substrate 210. Growing the semiconductor component may comprise performing molecular beam epitaxy, a chemical vapour deposition process such as metalorganic vapour phase epitaxy ("MOVPE"), or the like.

In some implementations, the semiconductor component may be grown by selective area growth ("SAG"). SAG makes use of a mask to control the growth, such that semiconductor grows at selected locations. For example, SAG may be used to grow semiconductor nanowires, or a network of such nanowires. Where SAG is used, the mask may remain in the finished device. In such implementations, the mask is considered part of the semiconductor structure 210.

The semiconductor component may comprise a single material, or multiple materials. Where the semiconductor component comprises more than one material, more than one growth technique and/or more than one set of growth conditions may be used.

In the present example, the semiconductor component 214 is grown before shadow wall 230 is formed. Growing the semiconductor component in the absence of shadow walls may allow the growth conditions for the semiconductor component to be optimized freely. Growing the semiconductor component in the absence of shadow walls may allow a wider range of semiconductor component configurations. For example, the thickness of the semiconductor component may be freely varied.

Semiconductor components may be grown in the presence of shadow walls, however this may impose additional constraints on growth conditions and/or the configuration of the semiconductor components. Growing semiconductor components in the presence of shadow walls may impose an upper limit on the thickness of the semiconductor component. Shadow walls may interfere with semiconductor growth by limiting adatom diffusion across the surface of the substrate.

The operations of block 101A are typically performed in an ultra-high vacuum.

At block 101B, after preparing the semiconductor structure 210, a capping layer 220 is deposited over the semiconductor structure 210. This yields a workpiece of the type illustrated in Fig. 2A.

The capping layer 220 serves to protect the semiconductor structure 210 during subsequent processing steps. In particular, the capping layer 220 protects the surface of semiconductor component 214. In addition, during formation of a shadow wall in phase 2 of the method, the thickness of the capping layer 220 will determine the spacing between body of the shadow wall and the top surface of the semiconductor structure.

The capping layer 220 is a layer of arsenic or antimony. The arsenic or antimony is typically in an amorphous form.

The capping layer 220 may be deposited at a low temperature in an ultra-high vacuum, for example at temperatures of less than or equal to 70°C, optionally less than or equal to 30°C. Maintaining the workpiece at a low temperature may be desirable in implementations where the semiconductor structure is temperature-sensitive.

The arsenic or antimony may be supplied as elemental arsenic or antimony; or in the form of an appropriate precursor which undergoes a reaction *in situ* to produce arsenic or antimony. An example precursor for arsenic is arsine. When the semiconductor component 214 comprises a material which includes arsenic or antimony, the arsenic or antimony source used in the growth of the semiconductor component may conveniently be used to deposit the capping layer.

The thickness of the capping layer 220 may be readily controlled, and may be selected as appropriate based on the desired spacing between the shadow wall and the semiconductor structure. The capping layer may have a thickness of at least 15 nm, optionally at least 20 nm, as this may allow a smooth capping layer to be obtained reliably.

The operations of the first phase may be performed while maintaining the workpiece under vacuum, e.g. a high vacuum or ultra-high vacuum. The workpiece is not removed from the vacuum until after block 101B is completed. This may maintain a pristine surface of the semiconductor component. A pristine surface is an "as-grown" surface, substantially free of native oxides and contaminants.

For example, the operations of blocks 101A and 101B may both be performed in a semiconductor growth chamber. Alternatively, blocks 101A and 101B may be performed in respective different chambers if the chambers are coupled such that the workpiece can be transferred between the chambers without exposure to the open atmosphere. An apparatus comprising two or more vacuum chambers which are coupled in this way may be referred to as a cluster tool.

After completing the first phase, the method moves to a second phase, in which a shadow wall 230 is formed on the workpiece. The second phase comprises the operations of blocks 101C, 101D, and 101E of Fig. 1.

Throughout the second phase, the semiconductor component 214 is protected by capping layer 220. The workpiece may therefore be exposed to a wide range of processing conditions without damaging the surface of the semiconductor component 214. In particular, the capping layer 220 may protect the surface of the semiconductor component 214 from oxidation.

At block 101C, one or more apertures 222a, 222b in the capping layer 220 are formed. In the present example, the apertures are formed by etching the capping layer 220.

The apertures expose regions of the semiconductor structure 210. The legs of the shadow wall 230 will be affixed to the semiconductor structure in the exposed regions. The remainder of the semiconductor structure 210 remains protected by the capping layer 220.

The apertures may extend into semiconductor structure 210, as illustrated in Fig. 2B. In other words, the etch may further comprise etching trenches in the semiconductor structure. Providing such trenches may allow the shadow wall to be affixed more robustly to the semiconductor structure.

Where trenches are present, the trenches may be shallow and may have a depth of the order of a few nanometres, e.g. in the range 1 to 10 nm. It has been found that shallow trenches provide good adhesion. Typically, it is desirable to minimize the extent of the etch in order to maximize the quality of the semiconductor component.

The etch may be controlled by a mask. The mask may be formed by a lithographic process, such as electron beam lithography.

The conditions used for the etch are not particularly limited. The etching may be a plasma dry etch, or may be a wet etch.

It may be desirable for the regions of the semiconductor structure exposed by the etch to be as small as possible, and/or spaced as far as possible from regions of the semiconductor structure which will be used actively in the finished device. This may further help to prevent damage to the active regions of the semiconductor structure.

As an alternative to lithography and etching, the apertures in the capping layer may be formed by heating selected portions of the capping layer. For example, the apertures may be formed by laser ablation or the like.

Phase 2 continues with block 101D, in which a resist is applied over the semiconductor structure 210. The resist fills the apertures 222a, 222b formed in block 101C, and covers the top surface of the capping layer 230. Applying the resist may comprise spin-coating the semiconductor structure with a resist composition. The thickness of the resist will determine the thickness of the body of the shadow wall.

The nature of the resist is not particularly limited provided that, following exposure and development, a shadow wall which is compatible with the deposition process used later at block 103 is obtained.

For example, the resist may comprise hydrogen silsesquioxane, HSQ. Liquid compositions comprising HSQ are commercially available, and may be applied by spin-coating. HSQ is a negative electron beam resist which, upon exposure, is converted into a silicon oxide, SiOₓ. Silicon oxides have good compatibility with a range of deposition processes, including molecular beam epitaxy. Usefully, silicon oxides do not degas under the conditions used for molecular beam epitaxy.

More generally, inorganic negative electron beam resists may be used. Carbon can act as a dopant of semiconductor materials, and avoiding the use of resists containing carbon is therefore preferable in many implementations.

The resist is selectively exposed and developed at block 101E, to form a shadow wall 230 having legs at positions corresponding to the apertures 222a, 222b in the capping layer 220 and a body supported by the capping layer 220. Fig. 2C illustrates an example workpiece obtainable at this stage.

The conditions of the exposure and development may be selected as appropriate based on the nature of the resist chosen. For example, HSQ may be exposed using an electron beam, and developed using tetramethyl ammonium hydroxide, TMAH.

The exposure and development define the shape of the shadow wall 230. Resist in the apertures 222a, 222b is developed to form legs of the shadow wall. Regions of the resist on the surface of the capping layer are developed to form the body of the shadow wall.

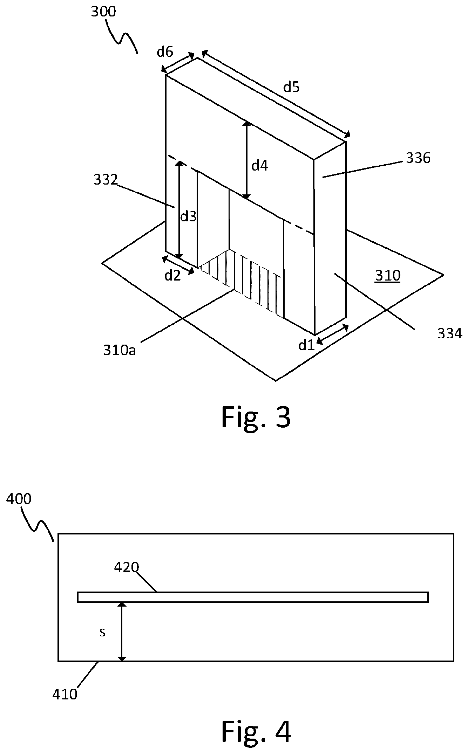

By controlling which regions of the resist are exposed, there is significant freedom to control the configuration of the finished shadow wall. Some example shadow walls will be discussed in more detail below, with reference to Figs. 3 to 6.

Optionally, if desired, more than one layer of resist may be applied, selectively exposed, and developed. This may allow shadow walls with more elaborate shapes to be obtained.

After forming the shadow walls, the method proceeds to phase 3. Phase 3 comprises removing the capping layer at block 102, and depositing one or more portions of one or more further materials over the semiconductor structure at block 103.

Phase 3 of the method may be performed while maintaining the workpiece under a vacuum, typically a high vacuum or ultra-high vacuum. For example, phase 3 may be performed in a molecular beam epitaxy apparatus.

In implementations where a mask is used to control the formation of the apertures in the capping layer, the mask is removed before transferring the workpiece to the vacuum. The mask may be removed before applying the resist at block 101D, or after forming the shadow wall at block 101E.

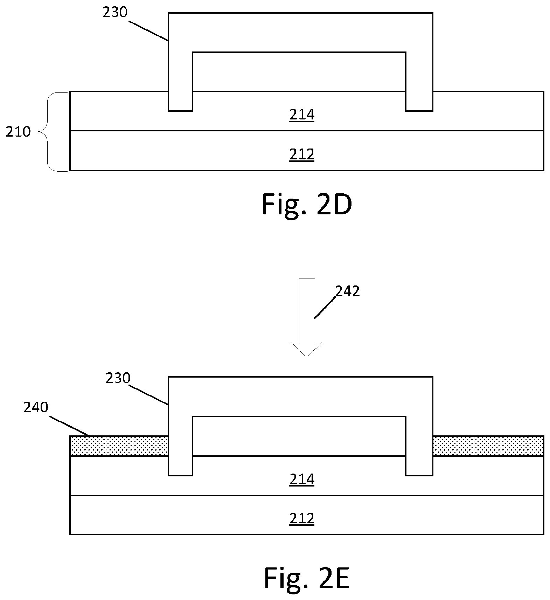

At block 102, the capping layer 230 is removed. Removing the capping layer exposes the semiconductor structure 210, as illustrated in Fig. 2D.

Removing the capping layer may comprise heating the capping layer under vacuum to sublime the arsenic or antimony. For example, the capping layer 230 may be heated to a temperature in the range 250 to 350 °C in an ultra-high vacuum. As will be appreciated, the temperature may be varied as appropriate depending on the pressure environment.

It has been found that capping a semiconductor structure with arsenic or antimony and subsequently removing the arsenic or antimony by heating under vacuum maintains the surface of the semiconductor structure in a pristine condition.

After removing the capping layer, at block 103, a layer of a further material 240 is deposited onto the semiconductor structure 210 to obtain a workpiece of the type shown in Fig. 2E.

The nature of the further material is not particularly limited. Non-limiting examples of further materials which may be deposited include metals, dielectrics, and ferromagnetic insulators.

The further material may comprise a metal. The metal may be a superconductor. The superconductor may be an s-wave superconductor. Examples include aluminium, indium, tin, and lead, with aluminium being preferred in some contexts.

Examples of dielectrics include silicon oxides, SiOₓ; silicon nitrites, SiNₓ; aluminium oxides, AlOₓ; and hafnium oxides, HfOₓ.

Examples of ferromagnetic insulators include EuS, EuO, GdN, Y₃Fe₅O₁₂, Bi₃Fe₅O₁₂, YFeO₃, Fe₂O₃, Fe₃O₄, Sr₂CrReO₆, CrBr₃/Crl₃, and YTiO₃.

Two or more further materials may be deposited. By way of illustration, block 103 may comprise depositing a metal and then depositing a dielectric.

To deposit a material, a flow of material 242 is directed toward the semiconductor structure 210. For example, the deposition may comprise molecular beam epitaxy.

The material is deposited on regions of the semiconductor structure 210 which are not shielded from the flow of material 242 by shadow wall 230. Shadowed regions do not receive the material.

The configuration of the shadowed regions determined by the shape of shadow wall 230 and the direction of flow 242.

Fig. 2E illustrates so-called "0-angle deposition", also referred to as line-of-sight deposition. In 0-angle deposition, the direction of flow of the material is perpendicular to the surface of the substrate. In 0-angle deposition, the shadowed regions lie directly under the body of the shadow wall. 0-angle deposition may provide shadows with sharply defined edges, or in other words, a high-resolution deposition.

Since the deposition of the further material(s) may be controlled precisely using the shadow walls, there is no need to perform any etch to pattern the further materials. By avoiding etching, the surface of the semiconductor component may be maintained in a pristine state.

Various modifications may be made to the described method.

The method may further comprise one or more additional operations. For example, after block 103, a further capping layer may be applied over the workpiece. The further capping layer may be a layer of arsenic or antimony. In such implementations, phases 2 and 3 of the method may be repeated to allowed patterned deposition of further materials. Alternatively, the capping layer may comprise a dielectric such as a hafnium oxide, for protecting the device.

Another example of an additional operation is adding gate electrodes. The shadow walls may be used to control deposition of the gate electrodes.

Still another example of an additional operation comprises forming a component on the shadow wall by depositing material onto the shadow wall. The component may comprise a gate electrode. The material deposited onto the shadow wall may comprise one or more metal layers and/or one or more dielectric layers. In some implementations, a gate structure supported by a shadow wall may be referred to as a frame gate.

The shadow wall may optionally be removed after the deposition of the further material(s).

For ease of illustration, the example shows the formation of a single shadow wall, and deposition of one layer of one further material. As will be appreciated, a plurality of shadow walls may be formed, and two or more layers of any number of different further materials may be deposited.

Fig. 3 is a schematic perspective view of an example shadow wall 300 arranged on a surface 310. Surface 310 may be the top surface of a semiconductor structure, such as semiconductor structure 210 of Figs. 2A to 2E.

Shadow wall 300 includes legs 332, 334 extending from the surface 310. A body 336 bridges the legs 332, 334 and is spaced from the surface 310 by a distance d3. Distance d3 is determined by the thickness of the capping layer present during fabrication of the shadow wall in phase 2 of the method of Fig. 1. Distance d3 is desirably small, e.g. 20 to 50 nm. A small spacing between the body 336 and the surface 310 may improve the resolution of the deposition, particularly when the shadow wall is used to control a 0-angle deposition process.

The shape, positions and dimensions d1, d2 of the legs may be controlled by varying the configuration of the apertures formed in block 101C of Fig. 1. The thickness d4 of the body 336 may be controlled by varying the thickness of the resist applied at block 101D of Fig. 1. The shape and dimensions d5, d6 of the body 336 may be controlled by selective exposure of the resist, at block 101E of Fig. 1.

In implementations where the shadow wall is formed after fabricating the semiconductor structure, constraints on the configuration of the shadow wall may be lifted, since there is no requirement for the shadow wall to be compatible with semiconductor growth conditions.

In use, when a flow of material is directed toward the semiconductor structure 310 from a direction perpendicular to the surface of the semiconductor structure 310, the shadow wall 300 shadows a region 310a which is directly below the body 336. As will be appreciated, differently shaped shadows would be obtained if the material were applied from a different direction.

Fig. 4 shows a schematic plan view of the body of a second example shadow wall 400. The illustrated shadow wall 400 has a generally rectangular outer perimeter 410. Legs for supporting the shadow wall would be arranged at or proximate to the outer perimeter 410.

An aperture 420 in the shape of an elongate slot is arranged toward the middle of body of the shadow wall 400. In use, superconductor material is deposited through the aperture 420 to form a strip of superconductor in the form of a nanowire on an underlying semiconductor structure.

The aperture 420 is spaced from the perimeter 410 by a distance s. By spacing the aperture from the location of the legs, it may be made possible to deposit material far away from etched regions of the semiconductor structure, and which are therefore the least likely to be damaged during fabrication of the device.

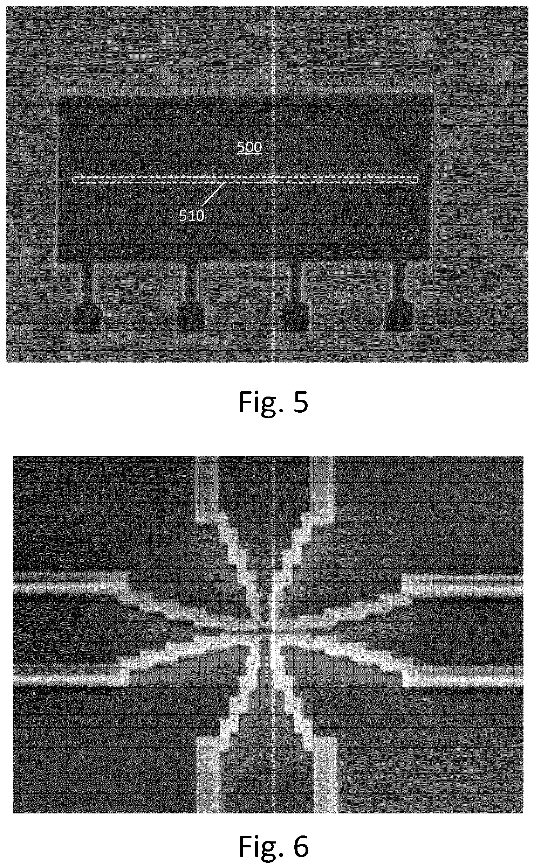

Fig. 5 shows a scanning electron microscopy image of a shadow wall of the type shown in Fig. 4. As may be seen, an aperture 510 for allowing deposition of a nanowire is provided in the body 500 of the shadow wall. To increase further the distance between the aperture and the legs, the legs are arranged on protrusions at the perimeter of the body.

An SEM image of a set of shadow walls is shown in Fig. 6. The illustrated shadow walls are configured to separate various electrodes and transmission lines of a semiconductor-superconductor hybrid device. The figure illustrates that complex shadow wall shapes may be readily achieved using the present methods. Since the shape of the shadow wall is defined lithographically, there is significant freedom to modify the configuration of the shadow walls depending on the nature of the desired device.

Although the examples described herein relate in particular to semiconductor-superconductor hybrid devices for quantum computing, the described methods are useful for fabricating any type of semiconductor device in which a pristine interface between a semiconductor component and a further component is desired.

It will be appreciated that the above embodiments have been described by way of example only.

More generally, according to one aspect of the invention as defined in claim 1, there is provided a method of fabricating a semiconductor device. The method includes providing a workpiece comprising a semiconductor structure, the semiconductor structure comprising a substrate and a semiconductor component arranged on a surface of the substrate; a capping layer over the semiconductor structure; and a shadow wall comprising a leg and a body connected to the leg. The capping layer is a layer of arsenic or antimony. The leg of the shadow wall extends from the semiconductor structure through an aperture in the capping layer. The body of the shadow wall is on the capping layer and over the semiconductor structure. The method further comprises removing the capping layer; and after removing the capping layer, depositing a further material onto a first region of the semiconductor structure. The shadow wall prevents deposition of the further material onto a second region of the semiconductor structure. The capping layer may protect the surface of the semiconductor component, and may be removed without degrading the quality of the surface of the semiconductor component. This may allow the further material to be deposited in an environment which is different from that in which the semiconductor structure is fabricated, while allowing a pristine interface between the semiconductor component and the further material to be obtained.

The first region may be referred to as an unshadowed region, and the second region may be referred to as a shadowed region.

The capping layer may be an *in situ* layer. An *in situ* layer is a layer formed in the same vacuum environment as the semiconductor component. When the capping layer is an *in situ* layer, the surface of the semiconductor component may be free of native oxides.

Providing the workpiece may include preparing the semiconductor structure, and depositing the capping layer over the semiconductor structure. Preparing the semiconductor structure may comprise growing the semiconductor component on a surface of the substrate. The preparation of the semiconductor structure and the deposition of the capping layer may be performed in a first environment. The first environment may comprise an ultra-high vacuum. The first environment may be in a chamber of a semiconductor growth apparatus.

The presence of shadow walls during growth of a semiconductor component may impose constraints on the growth, for example by restricting diffusion of atoms across the surface of the substrate. Growing the semiconductor component before forming the shadow wall may allow for a wider range of semiconductor components to be fabricated, and may allow for better optimization of growth conditions.

Providing the workpiece may further comprise forming the aperture by etching through the capping layer; applying a resist to fill the trench and cover the capping layer; and forming the shadow wall by selectively exposing the resist and developing the resist, with resist in the aperture being developed to form the leg, and resist over the capping layer being developed to form the body.

The resist may be an inorganic resist, for example hydrogen silsesquioxane. Carbon can act as a dopant for semiconductor materials, and avoiding the presence of carbon during deposition processes such as molecular beam epitaxy may therefore be advantageous.

Forming the aperture may comprise forming a mask over the capping layer by lithography, the mask having an opening which exposes a region of the capping layer; and etching the region of the capping layer exposed by the mask. In such implementations, the method further comprises, before removing the capping layer, removing the mask. The mask may be removed before applying the resist which fills the trench and covers the capping layer. Alternatively, the mask may be removed after forming the shadow wall and before removing the capping layer.

Alternatively, forming the aperture may comprise heating regions of the capping layer to sublimate the arsenic or antimony in the heated regions. For example, the aperture may be formed by laser ablation.

The semiconductor structure may be removed from the first environment before forming the aperture. For example, in implementations where the preparation of the semiconductor structure and the deposition of the capping layer are performed in a first apparatus, the method may further comprise, after depositing the capping layer and before removing the capping layer, removing the semiconductor structure from the first apparatus. Removing the semiconductor structure from the first apparatus may expose the semiconductor structure to air. The capping layer protects the semiconductor component from damage, allowing the semiconductor structure to be removed from a vacuum environment without degrading the semiconductor structure.

Forming the shadow wall may further comprise, after developing the resist, applying a second resist over the body; and selectively exposing and developing the second resist to extend the body. This may allow shadow walls with more complex three-dimensional shapes to be obtained. By varying the shape of the shadow wall, the locations at which the further material is deposited may be varied.

The semiconductor structure may include a trench, and the leg of the shadow wall may extend from the trench. Providing a trench in the semiconductor structure may allow for more robust attachment of the shadow wall to the semiconductor structure. The trench may, for example, have a depth of less than or equal to 30 nm.

The shadow wall may comprise a silicon oxide. Silicon oxides may have good compatibility with material deposition processes such as molecular beam epitaxy. To form a shadow wall comprising silicon oxide, a resist comprising hydrogen silsesquioxane may be used.

The further material may be deposited by a directional deposition process, such as molecular beam epitaxy. For example, the further material may be deposited from a direction perpendicular to the surface of the substrate. In other words, a zero-angle deposition process may be used. Depositing the further material from a direction perpendicular to the surface of the substrate may allow for high resolution deposition, i.e. a pattern of deposited material with clearly-defined edges may be obtained.

Removing the capping layer may comprise heating the capping layer under vacuum, optionally a high vacuum or ultra-high vacuum. Arsenic and antimony each sublime at moderate temperatures. Removal of the capping layer by heating may maintain a pristine surface on the semiconductor structure.

The shape of the shadow wall may be defined using lithographic techniques, for example by selectively exposing the resist to an electron beam. This may allow a high degree of control over the shape of the shadow wall. For example, the body of the shadow wall may include an aperture. Further material for forming an active region of a semiconductor device may then be deposited through the aperture. This may allow the active region to be spaced from the legs of the shadow wall. Spacing the active region from areas of the semiconductor structure which are exposed to etchant may improve the performance of the finished device.

The method may further comprise forming a component on the shadow wall. The component may comprise a metal layer and a dielectric layer. The component may be a gate structure. The component may be a frame gate.

The capping layer may be an amorphous layer. Amorphous layers of arsenic or antimony may be deposited onto a wide range of different materials.

The method may further comprise, after depositing the further material, depositing a second capping layer over the semiconductor structure. The second capping layer may be a further layer of arsenic or antimony. It is contemplated that further shadow walls may then be formed over the semiconductor structure, to allow for control over the deposition of further materials.

The nature of the semiconductor component is not particularly limited and may be selected as appropriate depending on the nature of the device to be fabricated. For example, the semiconductor component may comprise a semiconductor heterostructure for hosting a 2-dimensional electron gas or a 2-dimensional hole gas. The semiconductor heterostructure may comprise a quantum well layer arranged between two barrier layers.

In other implementations, the semiconductor component may be obtainable by selective area growth. In such implementations, the semiconductor structure may further comprise a dielectric mask.

The semiconductor structure may comprise a III-V semiconductor material. The III-V semiconductor material may include arsenic and/or antimony as component(s). In such implementations, the arsenic or antimony source used in the growth of the semiconductor component may also be used in the formation of the capping layer.

Examples of suitable III-V semiconductor materials include those of Formula 1:

InAsₓSb₁₋ₓ (Formula 1)

where x is in the range 0 to 1.

Further examples of III-V semiconductor materials include materials of Formula 2:

In_{y}Al_{1-y}As_{z}Sb_{1-z} (Formula 2)

where y is in the range 0 to 1, and z is in the range 0 to 1. The material of Formula 2 may be a quaternary material, in which both y and z are non-zero.

The nature of the further material is not particularly limited. The further material may comprise a metal, a dielectric material, a ferromagnetic insulator, or the like. For example, the further material may comprise a metal. Depositing a metal may form gate electrode(s), transmission lines, or the like on the semiconductor structure. The metal may be a superconductor. Since the methods provided herein are useful for maintaining the surface of the semiconductor component in a pristine state, the methods are well-suited for the fabrication of semiconductor-superconductor hybrid devices.

The method may be free of any etching steps following deposition of the further material.

In another aspect, the present invention provides the use of a layer of arsenic or antimony as a removable support for a body of a shadow wall, wherein the shadow wall further comprises a leg extending through an aperture in the layer. The layer may be arranged on or over a semiconductor structure, and may protect the semiconductor structure, in particular the surface of the semiconductor structure. Protecting the semiconductor structure may comprise preventing chemical changes to the semiconductor structure, such as preventing oxidation or hydrolysis. Protecting the semiconductor structure may comprise preventing contamination of the semiconductor structure, for example preventing sorption of species onto or into the semiconductor structure.

The use may be in the context of a method as described herein. The discussion of the various components and materials set out with respect to the method aspect are equally applicable to the use aspect.

In another aspect, the present invention provides a workpiece according to claim 13, comprising a semiconductor structure, the semiconductor structure comprising a substrate and a semiconductor component arranged on a surface of the substrate; a capping layer over the semiconductor structure; and a shadow wall comprising a leg and a body connected to the leg. The capping layer is a layer of arsenic or antimony. The leg of the shadow wall extends from the semiconductor structure through an aperture in the capping layer. The body of the shadow wall is on the capping layer and over the semiconductor structure. The workpiece is an intermediate product, useful in the methods described herein. Providing a capping layer which is a layer of arsenic or antimony may allow the capping layer to be removed during subsequent processing without degrading the surface of the semiconductor component.

As will be appreciated, the discussion of the components and materials set out above with respect to the method aspect is equally applicable to the workpiece aspect.

For example, the semiconductor structure may include a trench, and the leg of the shadow wall may extend from the trench. As previously described, this may affix the shadow wall more robustly to the semiconductor structure.

The shadow wall may comprise a silicon oxide. Many deposition techniques, such as molecular beam epitaxy, may be performed in the presence of silicon oxide shadow walls. Silicon oxide does not degas when exposed to a vacuum environment.

Other variants or use cases of the disclosed techniques may become apparent to the person skilled in the art once given the disclosure herein. The invention is not limited by the described embodiments but only by the accompanying claims.

## Claims

1. A method of fabricating a semiconductor device, which method comprises:
providing (101) a workpiece (200), the workpiece (200) comprising:
a semiconductor structure (210), the semiconductor structure (210) comprising a substrate (212) and a semiconductor component (214) arranged on a surface of the substrate (212);
a capping layer (220) over the semiconductor structure (210); and
a shadow wall (230) comprising a leg and a body connected to the leg;
wherein the capping layer (220) is a layer of arsenic or antimony;
wherein the leg of the shadow wall (230) extends from the semiconductor structure (210) through an aperture (222a) in the capping layer (200);
wherein the body of the shadow wall (230) is on the capping layer (220) and over the semiconductor structure (210);
removing (102) the capping layer (220);
after removing the capping layer (220), depositing (103) a further material (240) onto a first region of the semiconductor structure (210), wherein the shadow wall (230) prevents deposition of the further material (240) onto a second region of the semiconductor structure (210).

2. The method according to claim 1, wherein providing (101) the workpiece (200) comprises:
preparing (101A) the semiconductor structure (210);
depositing (101B) the capping layer (220) over the semiconductor structure (210),
forming the aperture (222a);
applying (101D) a resist to fill the aperture (222a) and cover the capping layer (220); and
forming (101E) the shadow wall (230) by selectively exposing the resist and developing the resist, with resist in the aperture (222a) being developed to form the leg, and resist over the capping layer (220) being developed to form the body.

3. The method according to claim 2, wherein the resist comprises hydrogen silsesquioxane.

4. The method according to claim 2 or claim 3, wherein forming the aperture comprises:
forming a mask over the capping layer (220) by lithography, the mask having an opening which exposes a region of the capping layer (220); and
etching the region of the capping layer (220) exposed by the mask;
wherein the method further comprises, before removing (102) the capping layer (220), removing the mask.

5. The method according to any of claims 2 to 4, wherein the preparation of the semiconductor structure (210) and the deposition of the capping layer (220) are performed in a first apparatus, and wherein the method further comprises, after depositing (101B) the capping layer (220) and before removing (102) the capping layer (220), removing the semiconductor structure (210) from the first apparatus.

6. The method according to any of claims 2 to 5, wherein forming (101E) the shadow wall (230) further comprises:
after developing the resist, applying a second resist over the body; and
selectively exposing and developing the second resist to extend the body.

7. The method according to any preceding claim, wherein the semiconductor structure (210) includes a trench, and the leg of the shadow wall (230) extends from the trench.

8. The method according to any preceding claim, wherein the shadow wall comprises a silicon oxide.

9. The method according to any preceding claim, wherein the further material (240) is deposited from a direction perpendicular to the surface of the substrate (212).

10. The method according to any preceding claim, wherein removing (102) the capping layer (220) comprises heating the capping layer (220) under vacuum.

11. The method according to any preceding claim, wherein the body of the shadow wall includes an aperture (420).

12. The method according to any preceding claim, wherein the capping layer (220) is an amorphous layer.

13. A workpiece (200), comprising:
a semiconductor structure (210), the semiconductor structure (210) comprising a substrate (212) and a semiconductor component (214) arranged on a surface of the substrate (212);
a capping layer (220) over the semiconductor structure (210); and
a shadow wall (230) comprising a leg and a body connected to the leg;
wherein the capping layer (220) is a layer of arsenic or antimony;
wherein the leg of the shadow wall (220) extends from the semiconductor structure (210) through an aperture (222a) in the capping layer (220);
wherein the body of the shadow wall (230) is on the capping layer (220) and over the semiconductor structure (210).

14. The workpiece according to claim 13, wherein the semiconductor structure (210) includes a trench, and the leg of the shadow wall (230) extends from the trench.

15. The workpiece according to claim 13 or claim 14, wherein the shadow wall (230) comprises a silicon oxide.

## Patentansprüche

1. Verfahren zum Herstellen einer Halbleitervorrichtung, wobei das Verfahren Folgendes umfasst:
Bereitstellen (101) eines Werkstücks (200), das Werkstück (200) umfassend:
eine Halbleiterstruktur (210), wobei die Halbleiterstruktur (210) ein Substrat (212) und eine Halbleiterkomponente (214) umfasst, die auf einer Oberfläche des Substrats (212) angeordnet ist;
eine Abdeckschicht (220) über der Halbleiterstruktur (210); und
eine Schattenwand (230), umfassend ein Bein und einen mit dem Bein verbundenen Körper;
wobei die Abdeckschicht (220) eine Schicht aus Arsen oder Antimon ist;
wobei sich das Bein der Schattenwand (230) von der Halbleiterstruktur (210) durch eine Öffnung (222a) in der Abdeckschicht (200) erstreckt;
wobei der Körper der Schattenwand (230) auf der Deckschicht (220) und über der Halbleiterstruktur (210) liegt;
Entfernen (102) der Abdeckschicht (220);
nach dem Entfernen der Abdeckschicht (220), Abscheiden (103) eines weiteren Materials (240) auf eine erste Region der Halbleiterstruktur (210), wobei die Schattenwand (230) die Abscheidung des weiteren Materials (240) auf eine zweite Region der Halbleiterstruktur (210) verhindert.

2. Verfahren nach Anspruch 1, wobei das Bereitstellen (101) des Werkstücks (200) Folgendes umfasst:
Herstellen (101A) der Halbleiterstruktur (210);
Abscheiden (101B) der Abdeckschicht (220) über der Halbleiterstruktur (210),
Bilden der Öffnung (222a);
Aufbringen (101D) eines Resists, um die Öffnung (222a) zu füllen und die Abdeckschicht (220) abzudecken; und
Bilden (101E) der Schattenwand (230) durch selektives Belichten des Resists und Entwickeln des Resists, wobei der Resist in der Öffnung (222a) entwickelt wird, um das Bein zu bilden, und der Resist über der Abdeckschicht (220) entwickelt wird, um den Körper zu bilden.

3. Verfahren nach Anspruch 2, wobei das Resist Wasserstoffsilsesquioxan umfasst.

4. Verfahren nach Anspruch 2 oder 3, wobei das Bilden der Öffnung Folgendes umfasst: Bilden einer Maske über der Abdeckschicht (220) durch Lithographie, wobei die Maske eine Öffnung aufweist, die eine Region der Abdeckschicht (220) freilegt; und
Ätzen der Region der Abdeckschicht (220), die von der Maske freigelegt wurde;
wobei das Verfahren ferner umfasst, dass vor dem Entfernen (102) der Abdeckschicht (220), die Maske entfernt wird.

5. Verfahren nach einem der Ansprüche 2 bis 4, wobei die Herstellung der Halbleiterstruktur (210) und die Abscheidung der Abdeckschicht (220) in einem ersten Gerät durchgeführt werden und wobei das Verfahren ferner, nach dem Abscheiden (101B) der Abdeckschicht (220) und vor dem Entfernen (102) der Abdeckschicht (220), das Entfernen der Halbleiterstruktur (210) aus dem ersten Gerät umfasst.

6. Verfahren nach einem der Ansprüche 2 bis 5, wobei das Bilden (101E) der Schattenwand (230) ferner Folgendes umfasst:
nach dem Entwickeln des Resists, Auftragen eines zweiten Resists auf den Körper; und
selektives Belichten und Entwickeln des zweiten Resists, um den Körper zu verlängern.

7. Verfahren nach einem der vorstehenden Ansprüche, wobei die Halbleiterstruktur (210) einen Graben einschließt und das Bein der Schattenwand (230) von dem Graben ausgeht.

8. Verfahren nach einem der vorstehenden Ansprüche, wobei die Schattenwand ein Siliziumoxid umfasst.

9. Verfahren nach einem der vorstehenden Ansprüche, wobei das weitere Material (240) aus einer Richtung senkrecht zur Oberfläche des Substrats (212) aufgebracht wird.

10. Verfahren nach einem der vorstehenden Ansprüche, wobei das Entfernen (102) der Abdeckschicht (220) das Erhitzen der Abdeckschicht (220) unter Vakuum umfasst.

11. Verfahren nach einem der vorstehenden Ansprüche, wobei der Körper der Schattenwand eine Öffnung (420) einschließt.

12. Verfahren nach einem der vorstehenden Ansprüche, wobei die Abdeckschicht (220) eine amorphe Schicht ist.

13. Werkstück (200), umfassend:
eine Halbleiterstruktur (210), wobei die Halbleiterstruktur (210) ein Substrat (212) und eine Halbleiterkomponente (214) umfasst, die auf einer Oberfläche des Substrats (212) angeordnet ist;
eine Abdeckschicht (220) über der Halbleiterstruktur (210); und
eine Schattenwand (230), umfassend ein Bein und einen mit dem Bein verbundenen Körper;
wobei die Abdeckschicht (220) eine Schicht aus Arsen oder Antimon ist;
wobei sich das Bein der Schattenwand (220) von der Halbleiterstruktur (210) durch eine Öffnung (222a) in der Abdeckschicht (220) erstreckt;
wobei der Körper der Schattenwand (230) auf der Deckschicht (220) und über der Halbleiterstruktur (210) liegt.

14. Werkstück nach Anspruch 13, wobei die Halbleiterstruktur (210) einen Graben einschließt und das Bein der Schattenwand (230) von dem Graben ausgeht.

15. Werkstück nach Anspruch 13 oder 14, wobei die Schattenwand (230) ein Siliziumoxid umfasst.

## Revendications

1. Procédé de fabrication d'un dispositif à semi-conducteur, lequel procédé comprend :
la fourniture (101) d'une pièce à usiner (200), la pièce à usiner (200) comprenant :
une structure semi-conductrice (210), la structure semi-conductrice (210) comprenant un substrat (212) et un composant semi-conducteur (214) agencé sur une surface du substrat(212) ;
une couche de recouvrement (220) sur la structure semi-conductrice (210) ; et
un mur d'ombre (230) comprenant une patte et un corps relié à la patte ;
dans laquelle la couche de recouvrement (220) est une couche d'arsenic ou d'antimoine ;
dans laquelle la patte du mur d'ombre (230) s'étend à partir de la structure semi-conductrice (210) à travers une ouverture (222a) dans la couche de recouvrement (200) ;
dans laquelle le corps du mur d'ombre (230) se trouve sur la couche de recouvrement (220) et sur la structure semi-conductrice (210) ;
le retrait (102) de la couche de recouvrement (220) ;
après le retrait de la couche de recouvrement (220), le dépôt (103) d'un autre matériau (240) sur une première région de la structure semi-conductrice (210), dans lequel le mur d'ombre (230) empêche le dépôt de l'autre matériau (240) sur une seconde région de la structure semi-conductrice (210).

2. Procédé selon la revendication 1, dans lequel la fourniture (101) de la pièce à usiner (200) comprend :
la préparation (101A) de la structure semi-conductrice (210) ;
le dépôt (101B) de la couche de recouvrement (220) sur la structure semi-conductrice (210),
la formation de l'ouverture (222a) ;
l'application (101D) d'une résine pour remplir l'ouverture (222a) et recouvrir la couche de recouvrement (220) ; et
la formation (101E) du mur d'ombre (230) par exposition sélective de la résine et développement de la résine, la résine présente dans l'ouverture (222a) étant développée pour former la patte, et la résine sur la couche de recouvrement (220) étant développée pour former le corps.

3. Procédé selon la revendication 2, dans lequel la résine comprend de l'hydrogène silsesquioxane.

4. Procédé selon la revendication 2 ou la revendication 3, dans lequel la formation de l'ouverture comprend : la formation d'un masque sur la couche de recouvrement (220) par lithographie, le masque ayant une ouverture qui expose une région de la couche de recouvrement (220) ; et
la gravure de la région de la couche de recouvrement (220) exposée par le masque ;
dans lequel le procédé comprend en outre, avant le retrait (102) de la couche de recouvrement (220), le retrait du masque.

5. Procédé selon l'une quelconque des revendications 2 à 4, dans lequel la préparation de la structure semi-conductrice (210) et le dépôt de la couche de recouvrement (220) sont exécutés dans un premier appareil, et dans lequel le procédé comprend en outre, après le dépôt (101B) de la couche de recouvrement (220) et avant le retrait (102) de la couche de recouvrement (220), le retrait de la structure semi-conductrice (210) du premier appareil.

6. Procédé selon l'une quelconque des revendications 2 à 5, dans lequel la formation (101E) du mur d'ombre (230) comprend en outre :
après le développement de la résine, l'application d'une seconde résine sur le corps ; et
l'exposition sélective et le développement de la seconde résine pour étendre le corps.

7. Procédé selon l'une quelconque revendication précédente, dans lequel la structure semi-conductrice (210) comporte une tranchée, et la patte du mur d'ombre (230) s'étend à partir de la tranchée.

8. Procédé selon l'une quelconque revendication précédente, dans lequel le mur d'ombre comprend un oxyde de silicium.

9. Procédé selon l'une quelconque revendication précédente, dans lequel l'autre matériau (240) est déposé selon une direction perpendiculaire à la surface du substrat (212).

10. Procédé selon l'une quelconque revendication précédente, dans lequel le retrait (102) de la couche de recouvrement (220) comprend le chauffage de la couche de recouvrement (220) sous vide.

11. Procédé selon l'une quelconque revendication précédente, dans lequel le corps du mur d'ombre comporte une ouverture (420).

12. Procédé selon l'une quelconque revendication précédente, dans lequel la couche de recouvrement (220) est une couche amorphe.

13. Pièce à usiner (200), comprenant :
une structure semi-conductrice (210), la structure semi-conductrice (210) comprenant un substrat (212) et un composant semi-conducteur (214) agencé sur une surface du substrat(212) ;
une couche de recouvrement (220) sur la structure semi-conductrice (210) ; et
un mur d'ombre (230) comprenant une patte et un corps relié à la patte ;
dans laquelle la couche de recouvrement (220) est une couche d'arsenic ou d'antimoine ;
dans laquelle la patte du mur d'ombre (220) s'étend à partir de la structure semi-conductrice (210) à travers une ouverture (222a) dans la couche de recouvrement (220) ;
dans laquelle le corps du mur d'ombre (230) se trouve sur la couche de recouvrement (220) et sur la structure semi-conductrice (210).

14. Pièce à usiner selon la revendication 13, dans laquelle la structure semi-conductrice (210) comporte une tranchée, et la patte du mur d'ombre (230) s'étend à partir de la tranchée.

15. Pièce à usiner selon la revendication 13 ou la revendication 14, dans laquelle le mur d'ombre (230) comprend un oxyde de silicium.
